# EUROPEAN PATENT APPLICATION

(11) **EP 0 812 007 A2**
(43) Date of publication of application: **10.12.1997**
(21) Application number: 97107875.3
(22) Date of filing: 14.05.1997
(51) Int. Cl.: H01L 21/00

(54) **Planarization of insulating film in formation of semiconductor device**

(30) Priority: 24.05.1996 JP 153298/96
(71) Applicant: NEC CORPORATION, Tokyo (JP)
(72) Inventor: Hayashi, Kanji, Minato-ku, Tokyo (JP)
(74) Representative: Glawe, Delfs, Moll & Partner

(57) **Abstract**

There is provided a method of planarizing an interlayer insulating film in the formation of a semiconductor device, including the steps of forming an interlayer insulating film, and polishing the interlayer insulating film, characterized by the steps of (a) forming interlayer insulating films (17, 18; 27, 28) by chemical vapor deposition (CVD) over a semiconductor substrate (1) on which a wiring (6) has been already formed, and (b) polishing the interlayer insulating films (17, 18; 27, 28) by chemical mechanical polishing (CMP) to planarize them. The method eliminates a gentle step which would remain not removed in high density line area in a conventional method, and can planarize an interlayer insulating layer without changing conditions for CMP. The method also makes it possible to planarize an interlayer insulating film in about half of time relative to a conventional method.

## Description

### BACKGROUND OF THE INVENTION

### FIELD OF THE INVENTION

The invention relates to a method of fabricating a semiconductor device, and more particularly to planarization of an interlayer insulating film in the formation of a semiconductor device.

### DESCRIPTION OF THE PRIOR ART

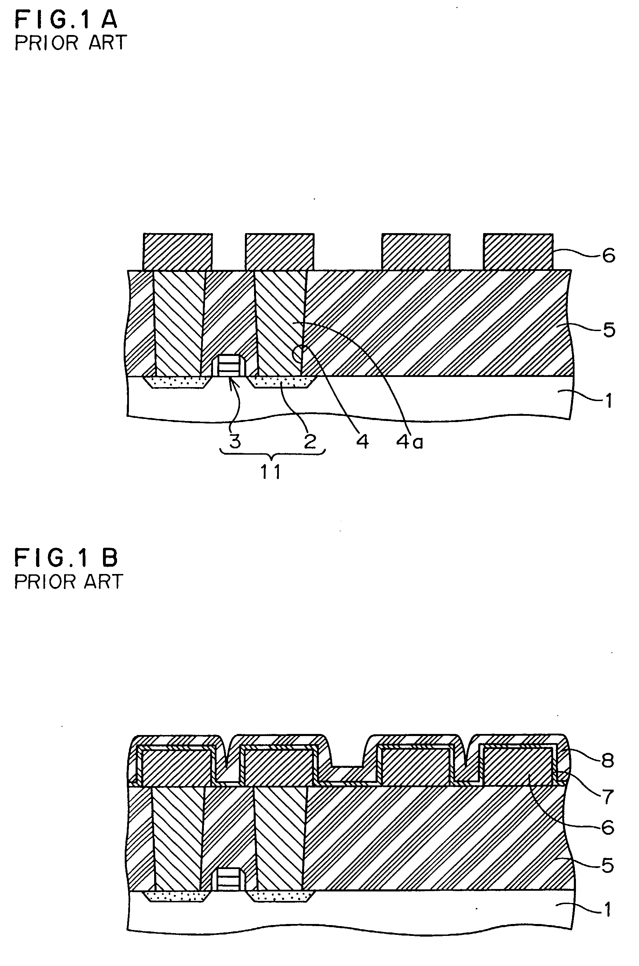

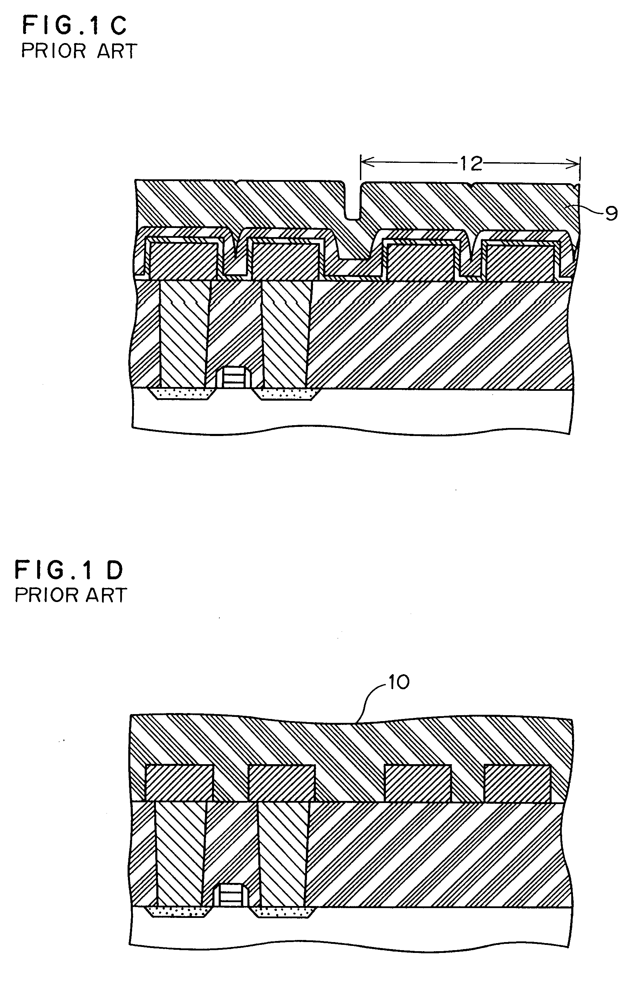

Figs. 1A to 1D illustrate respective steps of a conventional method of fabricating a semiconductor device. As illustrated in Fig. 1A, there is first formed a device 11 including impurity diffusion layers 2 in a semiconductor substrate 1 and a gate electrode 3 on the semiconductor substrate 1. After an interlayer insulating film 5 is formed over the semiconductor substrate 1, the interlayer insulating film 5 is formed with a contact hole 4, which is in turn filled with metal 4a. Then, aluminum is formed covering the interlayer insulating film 5 therewith, and then is patterned to thereby make a wiring layer 6.

Then, as illustrated in Fig. 1B, a resultant is covered with a first plasma oxide film 7, and further covered with an O₃ TEOS NSG film 8. Then, as illustrated in Fig. 1C, there is formed a second plasma oxide film 9 over a resultant, and thereafter the second plasma oxide film 9 is planarized, as illustrated in Fig. 1D.

In the conventional semiconductor device illustrated in Figs. 1A to 1D, an interlayer insulating film comprises the plasma oxide films 7, 9 and the O₃ TEOS NSG film 8. The conventional semiconductor device has a problem that the plasma oxide film 9 is continuously formed over the adjacent wiring layers 6 as indicated with a reference numeral 12 in Fig. 1C, resulting in a pseudo large area pattern in high density line area.

When chemical mechanical polishing (hereinafter, referred to simply as "CMP") is applied to the above mentioned conventional semiconductor device, it is the above mentioned interlayer insulating film that is to be polished by CMP. However, it would take longer time to planarize a larger area pattern by CMP. Thus, it took much time to conduct CMP to thereby planarize a pseudo large area pattern caused by an oxide film formed in high density line area. For instance, it took about 6 minutes in average per a wafer for planarizing a pattern.

In addition, there is another problem that there is formed a gently curved surface 10 on a pseudo large area pattern, as illustrated Fig. 1D. To solve this problem, there has been suggested the formation of a bias CVD film followed by CMP in SEMI Technology Symposium 1994, pp. 259-267. According to the suggestion, a sufficiently planar surface can be obtained by the formation of a bias CVD film followed by CMP by 2000 angstroms calculated in terms of a thickness of a solid oxide film.

Japanese Unexamined Patent Publication No. 60-115234 has suggested a method without conducting CMP. In this method, an insulating film is deposited on a wiring by bias sputtering in such a bias condition that the insulating film has an inclined surface, and then an insulating film is successively deposited by CVD or ordinary sputtering. Then, a resultant is covered with fluid material, and hereafter is heated at 140 °C for 30 minutes. By heating, the fluid material completely planarize local steps. Then, dry etching is conducted so that etching rates for the fluid material and the underlying insulating film are equal to each other, to thereby planarize the insulating film by etch-back.

As mentioned earlier, the prior methods have problems that it takes about 6 minutes for conducting CMP, and that there is formed the gently curves surface 10 in pseudo large area pattern after conducting CMP. In addition, the method suggested in SEMI Technology Symposium 1994 has a problem of low growth rate of a bias CVD film with the result of low throughput.

In addition, the method suggested in Japanese Unexamined Patent Publication No. 60-115234 needs 50 minutes for bias sputtering and further 30 minute for heating for planarization of the fluid material. Thus, the method has problems that throughput is quite low, and that it is impossible to eliminate a global curved surface formed on a pseudo large area pattern.

### SUMMARY OF THE INVENTION

It is an object of the present invention to provide a method which is capable of not forming a gently curved surface in high density line area, and also capable of planarizing an interlayer insulating film by CMP in conditions not dependent on a wiring pattern of a semiconductor device.

There is provided a method of planarizing an interlayer insulating film in the formation of a semiconductor device, including the steps of forming an interlayer insulating film, and polishing the interlayer insulating film, characterized by the steps of (a) forming interlayer insulating films by chemical vapor deposition (CVD) over a semiconductor substrate on which a wiring has been already formed, and (b) polishing the interlayer insulating films by chemical mechanical polishing (CMP) to planarize them.

The interlayer insulating films may include a lower film formed by bias CVD and an upper film formed by plasma.

The interlayer insulating films may include lower and upper ones in which a lower interlayer insulating film is formed by CVD in the step (a) and the lower interlayer insulating film is planarized by CMP in the step (b), and further the upper interlayer insulating film may be formed by plasma over the thus planarized lower interlayer insulating film.

It is preferable that the lower interlayer insulating film is formed so that the lower interlayer insulating film is not continuous over adjacent wirings.

There is further provided a method of fabricating a semiconductor device, including the steps of (a) forming a wiring on a semiconductor substrate with a first interlayer insulating film sandwiched therebetween, a semiconductor element having been already fabricated on the semiconductor substrate, (b) forming a second interlayer insulating film over the wiring, and (c) polishing the second interlayer insulating film, characterized by that the second interlayer insulating films are formed by CVD over both the wiring and the first interlayer insulating film, and that the second interlayer insulating films are polished by CMP to for planarization thereof.

The second interlayer insulating films may include lower and upper interlayer insulating films in which the lower interlayer insulating film is formed by bias CVD over the semiconductor substrate and the upper interlayer insulating film is formed by plasma over the lower interlayer insulating film.

As an alternative, the second interlayer insulating films may include lower and upper interlayer insulating films in which the lower interlayer insulating film is formed by CVD and the lower interlayer insulating film is planarized by CMP, and further the upper interlayer insulating film may be formed by plasma over the thus planarized lower interlayer insulating film.

An interlayer insulating film formed by bias ECR plasma provides superior coverage over wirings and sufficiently planarized surface. However, if an interlayer insulating film is formed only by bias ECR plasma, throughput for the formation of the film is quite low. Thus, in accordance with the present invention, a first half of an interlayer insulating film is formed by bias CVD, and a second half is formed by plasma to thereby form an interlayer insulating film having a desired thickness.

In accordance with the above mentioned present invention in which an interlayer insulating film is composed of a bias oxide film and a plasma oxide film, there is not formed a pseudo larger area pattern even in high density line area. Whereas it took about 6 minutes for planarizing an interlayer insulating film in accordance with the conventional methods, the present invention shortens a time for planarization to about 3 minutes which is just half of the time in the conventional methods.

In the conventional methods, the condition for CMP had to be varied for patterns, because there was formed a pseudo large area pattern in proportion to an area of high density line area. In contrast, there is not formed a pseudo large area pattern in the method in accordance with the present invention, and thus there is no need of varying conditions for CMP or a thickness to be polished by CMP.

In addition, the present invention does not allow a gently curved surface, which would remain in high density line area after planarization of an interlayer insulating film in the conventional methods, to be formed after planarization of an interlayer insulating film.

### BRIEF DESCRIPTION OF THE DRAWINGS

Figs. 1A to 1D are cross-sectional views of a semiconductor device, illustrating respective steps of a conventional method of fabricating the same.

Figs. 2A to 2D are cross-sectional views of a semiconductor device, illustrating respective steps of a method of fabricating the same in accordance with the first embodiment.

Figs. 3A to 3D are cross-sectional views of a semiconductor device, illustrating respective steps of a method of fabricating the same in accordance with the second embodiment.

### DESCRIPTION OF THE PREFERRED EMBODIMENTS

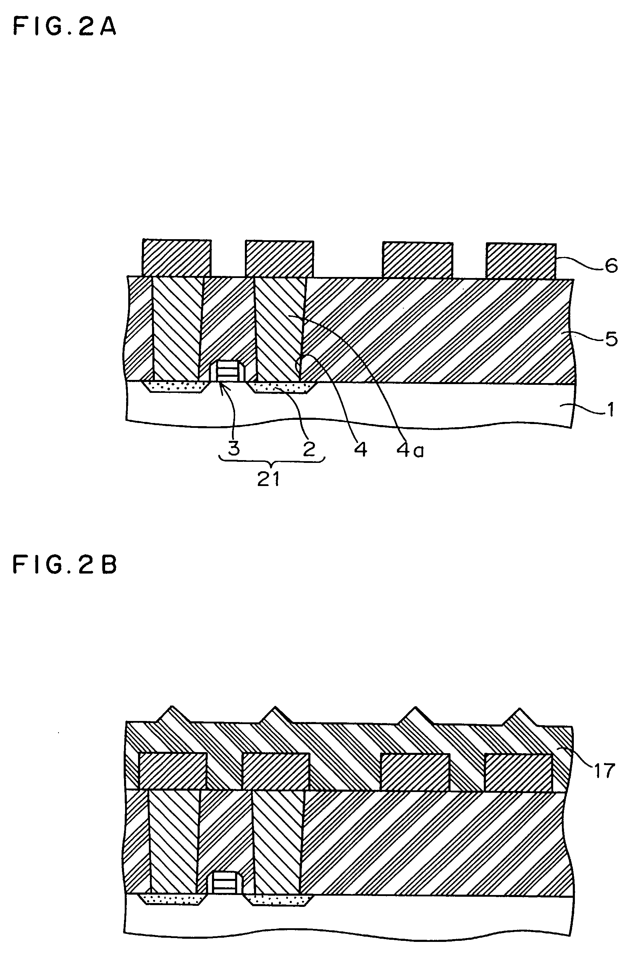

The first embodiment is explained hereinbelow with reference to Figs. 2A to 2D. As illustrated in Fig. 2A, there is first formed a device 21 including impurity diffusion layers 2 in a semiconductor substrate 1 and a gate electrode 3 on the semiconductor substrate 1. A silicon dioxide film as an interlayer insulating film 5 is formed over the semiconductor substrate 1, and then planarized by CMP.

Then, there is formed a contact hole 4 through the interlayer insulating film 5 in order to provide electrical communication to the device 21 therethrough. The contact hole 4 is filled with metal 4a.

Then, aluminum is formed by sputtering to entirely cover the interlayer insulating film 5 therewith, and then is patterned to thereby make a first wiring layer 6. In the instant embodiment, the first wiring layer 6 is made of aluminum, however, it should be noted that the first wiring layer 6 may be made of alloy of aluminum and silicon, alloy of aluminum and copper or a layered structure comprising an aluminum layer and a refractory metal layer such as a titanium (Ti) layer.

Then, as illustrated in Fig. 2B, there is formed a bias silicon dioxide film or bias ECR oxide film 17 by bias CVD covering the first wiring layer 6 therewith. The bias silicon dioxide film 17 is formed so that the film 17 is not continuous over the adjacent wiring layers 6 unlike the plasma oxide film 9 illustrated in Fig. 1C.

One of conditions for the formation of the bias silicon oxide film 17 is as follows.
Gas Flow Rate: SiH₄/O₂/Ar = 90/99/129 sccm
Microwave Power: 2000 W
RF Power: 1250 W
Pressure of He: 2 Torr

Then, as illustrated in Fig. 2C, there is formed an oxide film 18 by plasma over the bias CVD oxide film 17. One of conditions for the formation of the plasma oxide film 18 is as follows.
TEOS Flow Rate: 1.6 ml/m
High-Frequency Power: 0.60 kW
Low-Frequency Power: 0.40 kW
Pressure: 2.2 Torr

An example of thicknesses of the bias CVD oxide film 17 and the plasma oxide film 18 is as follows.
Bias CVD Oxide Film 17 = 1.4 µm
Plasma Oxide Film = 0.5 µm

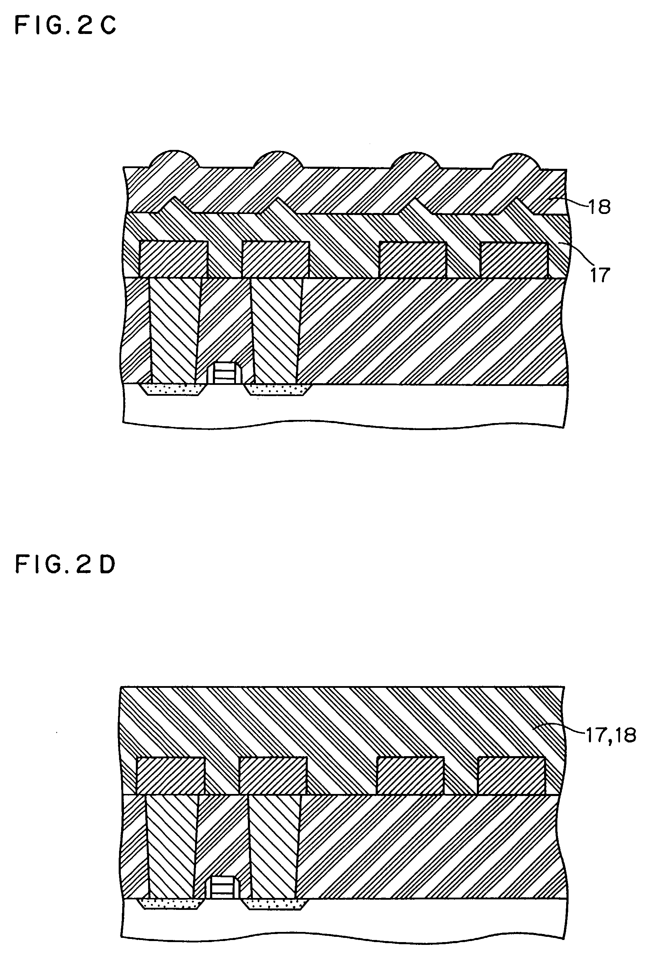

Then, as illustrated in Fig. 2D, the bias CVD oxide film 17 and the plasma oxide film 18 are both planarized by CMP. An example of conditions for CMP is as follows.
Spindle Speed = 15 rpm
Table Speed = 20 rpm
Pressure acting on a Wafer = 6 psi
Pressure acting on a reverse surface = 3 psi

In the first embodiment, there are first formed the oxide films 17 and 18 by CVD on the semiconductor substrate 1 on which the wiring 6 has already been formed, and then the CVD oxide films 17 and 18 are planarized by CMP.

The second embodiment in accordance with the present invention is explained hereinbelow with reference to Figs. 3A to 3D. As illustrated in Fig. 3A, there is first formed a device 31 including impurity diffusion layers 2 in a semiconductor substrate 1 and a gate electrode 3 on the semiconductor substrate 1. A silicon dioxide film as an interlayer insulating film 5 is formed over the semiconductor substrate 1, and then planarized by CMP.

Then, there is formed a contact hole 4 through the interlayer insulating film 5 in order to provide electrical communication to the device 31 therethrough. The contact hole 4 is filled with metal 4a.

Then, aluminum is formed by sputtering to entirely cover the interlayer insulating film 5 therewith, and then is patterned to thereby make a first wiring layer 6.

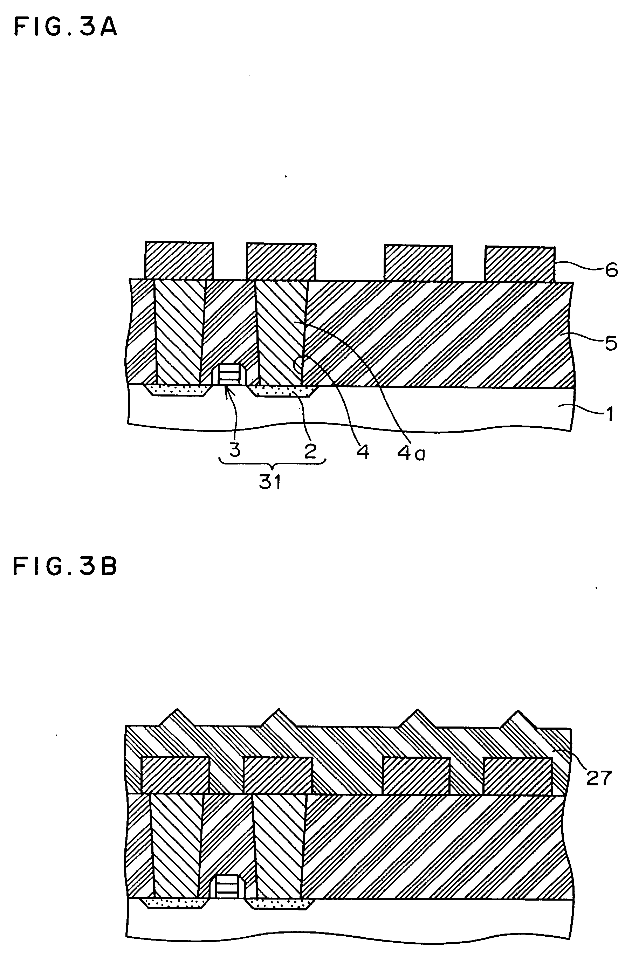

Then, as illustrated in Fig. 3B, there is formed a bias silicon dioxide film or bias ECR oxide film 27 by bias CVD covering the first wiring layer 6 therewith. Similarly to the bias silicon dioxide film 17 in the first embodiment, the bias silicon dioxide film 27 is formed so that the film 27 is not continuous over the adjacent wiring layers 6 unlike the plasma oxide film 9 illustrated in Fig. 1C. The condition for the formation of the bias silicon dioxide film 27 is the same as that of the first embodiment.

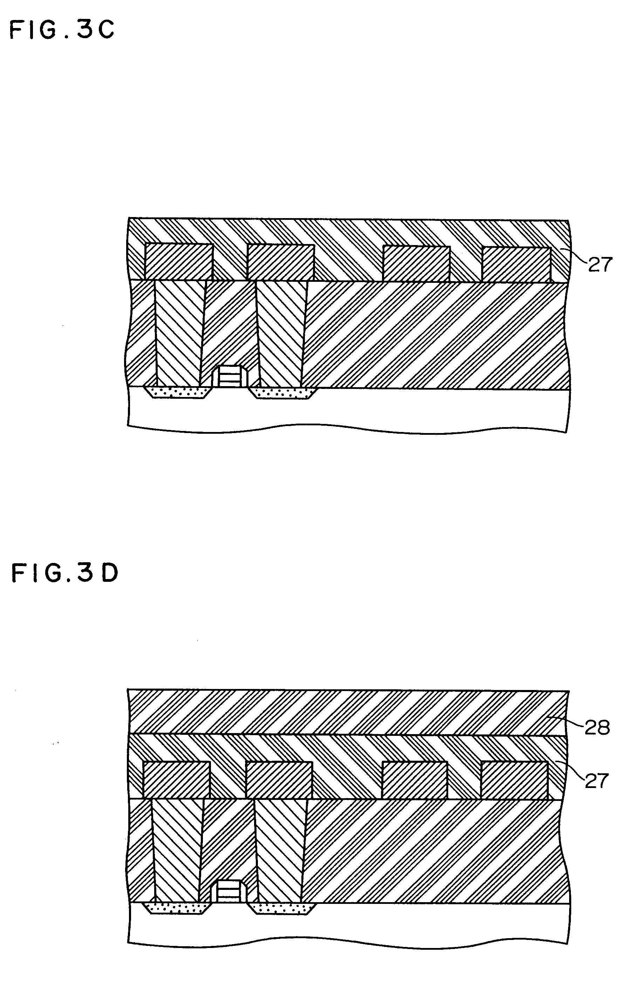

Then, as illustrated in Fig. 3C, the bias CVD oxide film 27 is planarized by CMP. The condition for CMP is the same as that of the first embodiment.

Then, as illustrated in Fig. 3D, there is formed an oxide film 28 by plasma on the thus planarized bias CVD oxide film 27. Since the bias CVD oxide film 27 has already been planarized, the plasma oxide film 28 can have a planar upper surface 28a.

As explained above, in the second embodiment, there is first formed the bias oxide film 27 by CVD on the semiconductor substrate 1 on which the wiring 6 has already been formed, and then the bias oxide films 27 is planarized by CMP. Thereafter, the plasma oxide film 28 is formed on the planarized bias oxide film 27.

## Claims

1. A method of planarizing an interlayer insulating film in the formation of a semiconductor device, comprising the steps of forming an interlayer insulating film, and polishing the interlayer insulating film, characterized by the steps of:
(a) forming interlayer insulating films (17, 18; 27, 28) by chemical vapor deposition (CVD) over a semiconductor substrate (1) on which a wiring (6) has been already formed; and
(b) polishing the interlayer insulating films (17, 18; 27, 28) by chemical mechanical polishing (CMP) to planarize them.

2. The method as set forth in claim 1, wherein the interlayer insulating films (17, 18; 27, 28) comprise a lower film (17, 27) formed by bias chemical vapor deposition and an upper film (18, 28) formed by plasma.

3. The method as set forth in claim 1, wherein the interlayer insulating films (17, 18; 27, 28) including lower and upper ones in which a lower interlayer insulating film (17, 27) is formed by CVD in the step (a) and the lower interlayer insulating film (17, 27) is planarized by chemical mechanical polishing (CMP) in the step (b), and further comprising the step (c) of forming the upper interlayer insulating film (18, 28) by plasma over the thus planarized lower interlayer insulating film (17, 27), the step (c) being carried out subsequently to the step (b).

4. The method as set forth in claim 2 or 3, wherein the lower interlayer insulating film (17, 27) is formed so that the lower interlayer insulating film (17, 27) is not continuous over adjacent wirings (6).

5. The method as set forth in claim 1, 2 or 3, wherein the lower and upper interlayer insulating films (17, 18; 27, 28) are oxide films.

6. A method of fabricating a semiconductor device, comprising the steps of: (a) forming a wiring (6) on a semiconductor substrate (1) with a first interlayer insulating film (5) sandwiched therebetween, a semiconductor element (21, 31) having been already fabricated on the semiconductor substrate (1); (b) forming a second interlayer insulating film over the wiring (6); and (c) polishing the second interlayer insulating film, characterized by:
that two of the second interlayer insulating films (17, 18; 27, 28) are formed by chemical vapor deposition (CVD) over both the wiring (6) and the first interlayer insulating film (5),
and that the second interlayer insulating films (17, 18; 27, 28) are polished by chemical mechanical polishing (CMP) to for planarization thereof.

7. The method as set forth in claim 6, wherein the second interlayer insulating films (17, 18; 27, 28) comprise lower and upper interlayer insulating films in which the lower interlayer insulating film (17, 27) is formed by bias chemical vapor deposition (CVD) over the semiconductor substrate (1) and the upper interlayer insulating film (27, 28) is formed by plasma over the lower interlayer insulating film (17, 27).

8. The method as set forth in claim 6, wherein the second interlayer insulating films (17, 18; 27, 28) comprise lower and upper interlayer insulating films in which the lower interlayer insulating film (17, 27) is formed by CVD and the lower interlayer insulating film (17, 27) is planarized by chemical mechanical polishing (CMP), and further comprising the step of forming the upper interlayer insulating film (18, 28) by plasma over the thus planarized lower interlayer insulating film (17, 27).

9. The method as set forth in claim 6, 7 or 8, wherein the second interlayer insulating films (17, 18; 27, 28) are oxide films.

10. The method as set forth in claim 6, 7 or 8, wherein the second interlayer insulating films (17, 18; 27, 28) are formed so that the second interlayer insulating films (17, 18; 27, 28) are not continuous over adjacent wirings (6).
